Europäisches Patentamt

**European Patent Office**

**Office européen des brevets**

(19)

(11) Publication number: **0 111 183**
**A2**

(12) **EUROPEAN PATENT APPLICATION**

(21) Application number: **83111431.9**

(22) Date of filing: **15.11.83**

(51) Int. Cl.³: **G 07 B 17/00**
**H 05 K 9/00**

(30) Priority: **15.11.82 US 441589**

(43) Date of publication of application:
**20.06.84 Bulletin 84/25**

(84) Designated Contracting States:
**BE CH DE FR GB LI NL SE**

(71) Applicant: **PITNEY BOWES, INC.**
**Walter H. Wheeler, Jr. Drive**
**Stamford Connecticut 06926(US)**

(72) Inventor: **Buan, Danilo P.**
**29 Hall Road**
**Easton, Conn. 06612(US)**

(72) Inventor: **Eckert, Alton B.**
**79 Toilsome Avenue**
**Norwalk, Conn. 06851(US)**

(74) Representative: **Lehn, Werner, Dipl.-Ing. et al,**
**Hoffmann, Eitle & Partner Patentanwälte Arabellastrasse**
**4 (Sternhaus)**
**D-8000 München 81(DE)**

(54) Shielding arrangement for electronic postage meter and electronic postage meter having such an arrangement.

(57) A meter includes an electronic circuit for controlling the operation of the postage meter and including capability for accounting for postage which has been printed, an exterior, non-conductive cover (12) enclosing the meter, a keyboard (16) having keys (22) for entering data into the circuit to effect operation of the postage meter, and a metal shield (26) inside the exterior, non-conductive cover and substantially enclosing most of the electronic components of the electronic postage meter but having an opening (30) for the meter display (18), wherein a metal screen (34) is positioned over the opening (30) in the shield (26) whereby electromagnetic radiation interference is effectively prevented from reaching the electronic components.

Fig.2.

- 1 -

SHIELDING ARRANGEMENT FOR ELECTRONIC POSTAGE METER AND
ELECTRONIC POSTAGE METER HAVING SUCH AN ARRANGEMENT

The present invention relates to postage meters, and to shielding arrangements for electronic postage meters.

Electronic postage meters have been developed with electronic accounting and other circuitry. Postage meters of this type are disclosed in U.S. Patent No. 3,978,457 for Microcomputerized Electronic Postage Meter System and in U.S. Patent No. 3,938,095 for Computer Responsive Postage Meter. Keyboards are provided in the electronic postage meters to allow the user to enter the amount of postage to be printed, and to actuate various functions in the meter such as to recall for display the amount in the ascending register, which provides a total of all postage printed by the meter, and the amount in the descending register, which is the amount of the remaining postage which may be printed.

The electronic accounting circuits of the postage meter process the information which may be entered via the keyboard. The circuits include non-volatile memory capability for storing postage accounting information which is part of the postage meter registers. Programs for the proper operation of the meter are also stored in additional memory circuits. The memory and accounting circuits perform the functions served in previous postage meters by mechanical accounting registers.

Electronic postage meters, like mechanical postage meters, have a requirement for a high level of security. This is because the postage available for printing which is stored in the meter represents postage that has been previously purchased by a user from the postal services. As a result, the information stored in the registers has a monetary value. Accordingly, the meter must be made resistant against intentional or inadvertent unauthorized changes in the registers. If, for example, an unauthorized increase occurred in the meter's descending register, then postage would be available to be printed for which payment had not been made. On the other hand, if an unauthorized decrease were to occur in the meter's descending register, then postage would not be available for printing for which payment had been made.

Electromagnetic radiation interference can adversely affect the functioning of an electronic postage meter. This radiation includes radiation in the radio frequency spectrum, which is generally considered to range from approximately 5 kilohertz to in excess of 1000 megahertz. The radio frequency spectrum encompasses some audio frequencies, television and radar frequencies. Electromagnetic radiation can result in a loss or distortion of data or programs stored in the meter and a concomitant improper operation of the meter including possible improper accounting for postage which has been printed or which is available to be printed. These effects can result in the meter being rendered totally inoperative.

Prior art attempts at preventing electromagnetic radiation from reaching the electronic components of the electronic postage meter include using individual shields for each component. Such a system, however, creates difficult problems when it is desired to change the design of any single component. In co-pending application Serial No. _____ filed of even date herewith, entitled "Shielding System for Electronic Postage Meter" a single shield is proposed for preventing electromagnetic radiation from reaching the electronic components within an electronic postage meter. Since the shield is separate and independent of the cover for the postage meter, the cover and/or keyboard can be easily changed to accommodate various aesthetic requirements in different markets without effecting any change in the functioning of the meter. The shield, however, includes an opening for the meter display, and the instant invention is therefore directed to a metal screen to be placed over this opening in order to prevent electromagnetic radiation from reaching any of the electronic components within the electronic postage meter, and which also provides optical contrast.

The present invention provides an improvement in an electronic postage meter for printing postage on a mail piece. The meter includes an electronic circuit for controlling the operation of the postage meter, the circuit including means for accounting for postage which has been printed, an exterior, non-conductive cover enclosing said meter, a keyboard having switch means for entering data into the circuit to effect operation of the postage meter, and a metal shield which is inside the exterior, non-conductive cover and encloses at least some of the electronic components of the electronic postage meter but has an opening for the meter display. The improvement comprises a metal screen positioned over said opening in said shield whereby electromagnetic radiation interference is effectively prevented from reaching the electronic components of the meter.

For a better understanding of the invention, and to show how the same may be carried into effect, reference will now be made, by way of example, to the accompanying drawings, in which:

Figure 1    is a perspective view of a postage meter with the keyboard's bezel partially broken away;

Figure 2    is a schematic, perspective view of a postage meter cover and electromagnetic radiation interference helmet and screen according to the present invention;

Figure 3    is a sectional view taken on the plane indicated by the line 3-3 in Figure 1; and

Figure 4    is a perspective view of a metal screen positioned over an LED display within the meter, under the viewing window in the helmet, and also over a keyboard membrane situated over the helmet.

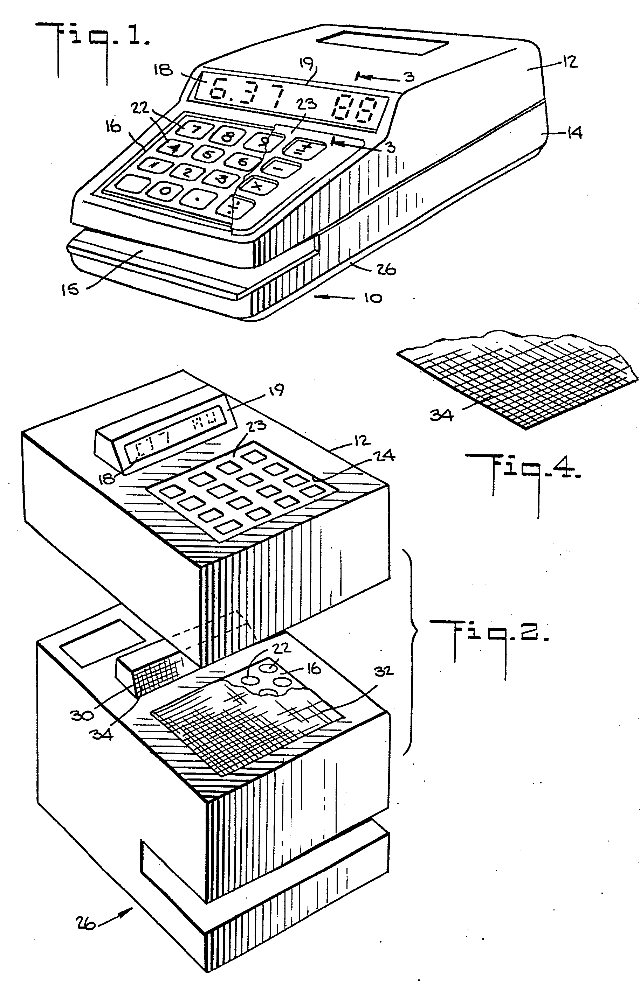

In describing the preferred embodiment of the present invention, reference is made to the drawings in which Figure 1 shows a postage meter generally designated 10 having a top cover 12 and a bottom cover 14. The particular construction of the postage meter housing and the internal components of the postage meter circuitry may be of conventional design. The meter 10 includes circuitry (not shown) for storing programs to control the operation of the meter mechanism and to store postal information such as the amount of postage printed by the meter and the amount of postage remaining in the meter for subsequent printing. The term postage meter is used to refer to the general category of devices for imprinting a defined unit value for governmental or private carrier delivery of envelopes or parcels, or other like application for unit value printing. Thus, the term is used as a general term for devices utilized in conjunction with services other than those employed exclusively by governmental postal services, such as private parcel or freight service meters.

The meter 10 includes a slot 15 adapted to receive a mail piece (not shown). When a mail piece is inserted in the slot 15, a mechanism is actuated which causes an imprinting of postage on the mail piece. The amount of postage to be printed on the mail piece is entered into the meter via a keyboard membrane 16 and is displayed on an LED meter display 18 through a display window 19. Switch contacts (not shown) of the keyboard 16 are electrically connected to postage meter circuitry and to a speaker (not shown). When any of the keys 22 of the keyboard 16 are depressed through a keyboard cover 23, the speaker emits an audible sound, which is particularly desirable in monolythic keyboards of the type where the movement to cause a switch actuation is extremely small relative to a prior art mechanical type switch mechanism.

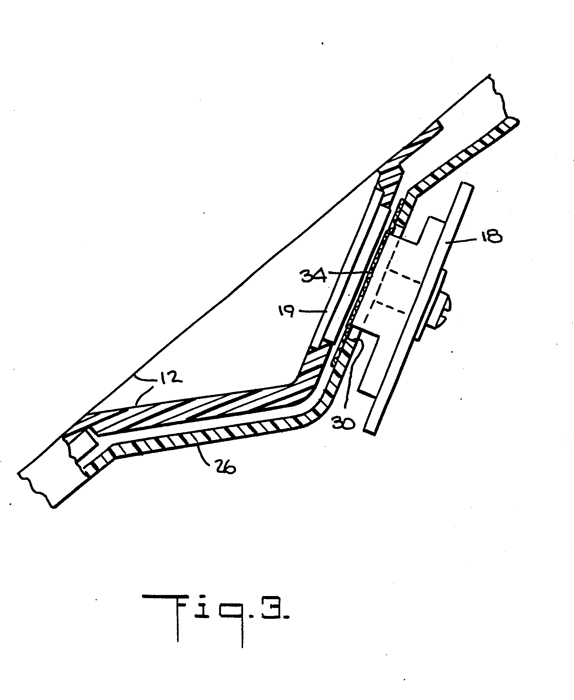

Referring now to Figure 2, there is seen the top cover 12 which is non-conductive and formed from synthetic plastics material (as is the bottom cover 14) and which includes an opening 24 to receive the keyboard 16 and keyboard cover 23. Situated underneath the top cover 12 and substantially surrounding all of the components of the meter 10 is a helmet or shield 26 formed from a metal preferably about 0.060 inch (0.152 cm) thick. To protect against high frequency electromagnetic radiation, a conductive and preferably ferrous material should be used, carbon steel being preferred for most applications. The thickness of the metal may vary between about 0.010 inch (0.025 cm) and 0.100 inch (0.254 cm); however, the preferred range is 0.040 inch (0.102 cm) to 0.100 inch (0.254 cm), most preferably 0.060 inch (0.152 cm) since a shield of this thickness can serve as a structural member and support other elements of the meter. The helmet 26 is grounded to the main body of the postage meter, and includes an opening 30 for the meter display 18. The helmet 26, though shown as integral, may be formed from a plurality of pieces fixedly secured to each other.

In order to prevent electromagnetic radiation interference from reaching the meter components through the opening 30, a transparent metal screen 34, preferably stainless steel, is placed over the opening 30. The screen can be any electrically conductive material which can form such a transparent screen, such as copper, and is grounded to the main body of the postage meter 10. Since it is not desirable to have a shiny, reflective display window 19, it is preferred that the metal screen 34 be darkened. In the case of stainless steel, the darkening can be achieved by acid etching. To prevent electromagnetic radiation from reaching the keyboard membrane 16, a metal screen 32 such as stainless steel is placed over the keyboard 16, and it is also grounded to the main body of the postage meter 10, independently of the screen 34. A preferred stainless steel screen is one having a 230 mesh with wire diameter of 0.0014 inch (0.00356 cm). The preferred range of the mesh is between about 200 and 250.

While the present invention has been described with reference to the particular structure disclosed herein, it is not intended that it be limited to the specific details and this application is intended to cover such modifications or changes as may come within the purposes of the improvements or scope of the claims forming a part hereof.

Claims:

1. A shielding arrangement for an electronic postage meter (10) for printing postage on a mail piece and having an electronic circuit for controlling the operation of said postage meter, said circuit including means for accounting for postage which has been printed, an exterior non-conductive cover (12,14) enclosing said meter, and a keyboard (16) having switch means (22) for entering data into said circuit to effect operation of said postage meter, said arrangement comprising a metal shield (26) for positioning within said exterior non-conductive cover for enclosing at least some of the electronic components of said electronic postage meter but having an opening (30) for a meter display (18), characterised by a metal screen (34) positioned over said opening in said shield (26) whereby electromagnetic radiation interference can be effectively prevented from reaching said at least some of the electronic components.

2. An arrangement according to claim 1 characterised in that the metal shield (26) comprises a ferrous metal.

3. An arrangement according to claim 2 characterised in that the ferrous metal comprises stainless steel.

4. An arrangement according to any one of claims 1 to 3 characterised in that the metal screen comprises stainless steel.

5. An arrangement according to claim 4 characterised in that the stainless steel screen is acid etched.

6. An arrangement according to any one of claims 1 to 5 characterised in that the thickness of the metal shield is between about 0.010 inch (0.025 cm) and 0.100 inch (0.254 cm).

7. An arrangement according to claim 6 characterised in that the thickness of the metal shield is between about 0.040 inch (0.102 cm) and 0.100 inch (0.254 cm).

8. An arrangement according to claim 7 characterised in that the thickness of the metal shield is about 0.060 inch (0.152 cm).

9. An arrangement according to any one of the preceding claims characterised in that the metal screen is darkened to increase optical contrast.

10. An arrangement according to any one of the preceding claims characterised in that the metal screen is grounded.

11. An arrangement according to any one of the preceding claims characterised in that the metal shield comprises a structural member.

12. A postage meter or franking machine characterised by a shielding arrangement according to any one of the preceding claims.

Fig.1.

Fig.2.

Fig.4.

Fig.3.